# EUROPEAN PATENT APPLICATION

(11) **EP 1 568 983 A1**
(43) Date of publication of application: **31.08.2005**
(21) Application number: 03775952.9
(22) Date of filing: 28.11.2003
(51) Int. Cl.: G01M 11/00, G01J 1/00, G01R 31/26, H01L 27/14, H04N 17/00

(54) **INSTRUMENT FOR TESTING SOLID-STATE IMAGING DEVICE**

(30) Priority: 06.12.2002 JP 2002355254; 12.02.2003 JP 2003033871
(71) Applicant: Inter Action Corporation, Kanagawa 236-0004 (JP)
(72) Inventor: TAMAI, Shingo, 14F Yokohama-kanazawa, Yokohama-Shi, Kanagawa 236 (JP)
(74) Representative: Feakins, Graham Allan
(86) International application number: PCT/JP2003/015258
(87) International publication number: WO 2004/053451

(57) **Abstract**

A testing apparatus, by which an optical system to irradiate a test light to a solid-state imaging device is easily aligned with the solid-state imaging device and highly efficient tests can be conducted, is provided.

It includes an optical module 35 for irradiating a light from a light source to a light receiving surface of the solid-state imaging device through a pin hole, a probe card 20 having contact probes for contacting pads of the solid-state imaging device, and a motor 30 and a holding arm 31 for moving the optical module 35 to a predetermined position corresponding to the solid-state imaging device to be tested through an opening 20h provided to the probe card 20 in a state where the contact probes 21 contact the pads of the solid-state imaging device to be tested.

## Description

### TECHNICAL FIELD

The present invention relates to a testing apparatus of a solid-state imaging device, and a relay device and an optical module used for testing a solid-state imaging device.

### BACKGOUND ART

In a production process of a solid-state imaging device, such as a CCD (Charge Coupled Device) and a CMOS (Complementary Metal Oxide Semiconductor), testing of photoelectric conversion characteristics of the solid-state imaging device is necessary. In the testing, there are pre-process tests conducted in a chip state where the solid-state imaging device is formed on a semiconductor wafer and post-process tests conducted after the solid-state imaging device is assembled and packaged.

In the pre-process tests, for example, in a state where a test head and a solid-state imaging device are electrically connected by using a probe card, a test light is irradiated to a light receiving surface of the solid-state imaging element through a predetermined optical system having a pin hole.

In the post-process tests, for example, by mounting a packaged solid-state imaging device on a socket board by a handler, a test head and the solid-state imaging device are electrically connected, and a test light is irradiated to the light receiving surface of the solid-state imaging device in this state through a predetermined optical system having a pin hole.

The above optical system is set to attain an F value of a predetermined value (or a predetermined exit pupil distance). Note that the F value is determined by a ratio of a diameter of the pin hole and the exit pupil distance.

There are some cases where the optical system for irradiating a light has to be very close to the light receiving surface of the solid-state imaging device to obtain a desired F value depending on a specification and a kind of the solid-state imaging device.

However, since there are a probe card and a socket board between the optical system and the solid-state imaging device, the degree of freedom is restricted by their existence in a positional relationship of the optical system and the solid-state imaging device. Therefore, it is difficult to improve the testing efficiency.

Also, the solid-state imaging device is mounted on the testing apparatus automatically by a handler, but alignment accuracy of the handler is not very high. When positions of the optical system and the solid-state imaging device vary in each measurement, an incident angle of a light to the solid-state imaging device changes in each measurement and an output of the solid-state imaging device varies, so that accurate measurement is hard to be made. In a solid-state imaging device, such as a CCD and a CMOS, there is known a technique of improving sensitivity by arranging a micro lens above each light receiving element and increasing an equivalent aperture ratio, however, particularly the output notably varies in a solid-state imaging device provided with the micro lens.

### DISCLOSURE OF THE INVENTION

An object of the present invention is to provide a testing apparatus, and a relay device and an optical module used in the testing apparatus; by which an optical system for irradiating a test light to a solid-state imaging device is easily aligned with the solid-state imaging device when testing photoelectric conversion characteristics by irradiating the light to the solid-state imaging device through a predetermined optical system, and a highly efficient test can be conducted.

Another object of the present invention is to provide a testing apparatus capable of eliminating a measurement error caused by variation of a positional relationship between a pin hole and a solid-state imaging device without declining the testing efficiency in a test for measuring characteristics by irradiating a light to the solid-state imaging device through the pin hole.

An optical module of the present invention is an optical module arranged facing a light receiving surface of a solid-state imaging device and used for irradiating a test light for the light receiving surface at testing photoelectric converting property of the solid-state imaging device, comprising: an optical lens; a diffusion plate adjusting an intensity distribution of a light passed through the optical lens; a pinhole passing the light from the diffusion plate; and a light blocking portion preventing an outside light from entering into an optical path leading from the lens to the pinhole.

A relay device of the present invention is a relay device transmitting necessary signals for a measurement of a photoelectric converting property of a solid-state imaging device by being connected electrically to the solid-state imaging device to be measured at testing the photoelectric converting property of the solid-state imaging device, comprising: an optical module arranged facing a light receiving surface of the solid-state imaging device and used for irradiating a test light for the light receiving surface at testing photoelectric converting property of the solid-state imaging device.

A testing apparatus of a solid-state imaging device according to a first aspect of the present invention is a testing apparatus for irradiating a light for a solid-state imaging device and testing a photoelectric converting property of the solid-state imaging device, comprising: an optical module outputting an entered light as a test light through a pinhole; a relay device transmitting necessary signals for a measurement of the photoelectric converting property of the solid-state imaging device by being connected electrically to the solid-state imaging device; and a means for moving and determining position moving the optical module at a position capable of outputting the light for the solid-state imaging device at a state that the relay device is connected electrically with the solid-state imaging device.

A testing apparatus of a solid-state imaging device according to a second aspect of the present invention is a testing apparatus for irradiating a light for a solid-state imaging device and testing a photoelectric converting property of the solid-state imaging device, comprising: an optical module irradiating a light lead along a predetermined optical path from a light source for the solid-state imaging device through a pinhole; a moving table holding the solid-state imaging device capable of moving in a plane being vertical to a light axis of the optical module; a means for moving the optical module outside the predetermined optical path; a half mirror inserted in the predetermined optical path at a state that the optical module is moved outside the optical path, transmitting the light from the light source proceeding to the solid-state imaging device, and reflecting a image of the solid-state imaging device irradiated by the light; a means for imaging the image reflected by the half mirror; a means for controlling the moving table so that the optical axis of the optical module is positioned at a predetermined position of the light receiving surface based on a graphic date of the light receiving surface imaged by the means for imaging.

### BRIEF DESCRIPTION OF DRAWINGS

FIG. 1 is a view of the configuration of a testing apparatus of a solid-state imaging device according to an embodiment of the present invention;
FIG. 2 is a sectional view showing the configuration of an optical module;
FIG. 3 is a view showing a state where a probe card and an optical module are aligned with a wafer;
FIG. 4 is a view showing the configuration of a probe card according to a second embodiment of the present invention;
FIG. 5 is a view showing the configuration of a probe card as a relay device according to another embodiment of the present invention;
FIG. 6 is a sectional view along the line A-A in FIG. 5;
FIG. 7 is a plan view of a card body in a state where the optical module is removed;
FIG. 8 is a view of an optical module on the side of a surface to be mounted to the card body;
FIG. 9 is a view showing a state where a test light is irradiated to each solid-state imaging device through a pin hole;
FIG. 10 is a view showing the configuration of a probe card as a relay device according still another embodiment of the present invention;
FIG. 11 is a view showing the configuration of a probe card as a relay device according still another embodiment of the present invention;
FIG. 12 is a view of the configuration of a testing apparatus of a solid-state imaging device according to an embodiment of the present invention;
FIG. 13 is a plan view showing the configuration of a turret;
FIG. 14 is a view showing a state of a testing apparatus before testing a solid-state imaging device; and
FIG. 15 is a view showing an example of a picked up image of a solid-state imaging device.

### BEST MODE FOR CARRYING OUT THE INVENTION

Below, preferred embodiments of the present invention will be explained in detail by using the drawings.

### First Embodiment

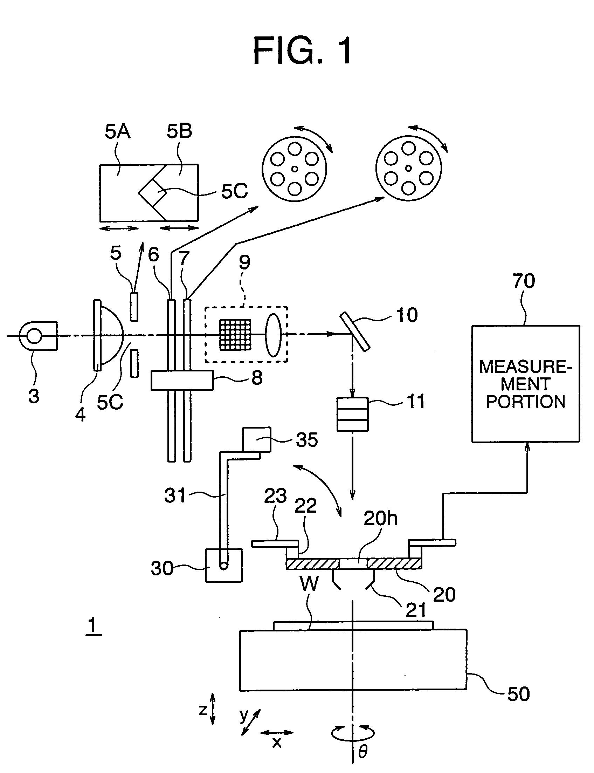

FIG. 1 is a view of the configuration of a testing apparatus of a solid-state imaging device according to an embodiment of the present invention.

In FIG. 1, a testing apparatus 1 has a light irradiation portion 2, a wafer table 50 and a measurement portion 70.

The light irradiation portion 2 has a light source 3, a condensing lens 4, a mechanical slit 5, an ND filter turret 6, a color filter turret 7, a homogenizer 9, a reflection mirror 10, a homogenizer 11, an optical module 35, a motor 30 and a holding arm 31.

The optical module 35 is an embodiment of the optical module of the present invention, and the motor 30 and the holding arm 31 compose an embodiment of the module moving means of the present invention.

As the light source 3, for example, a halogen lamp, a xenon lamp, and a metal halide lamp, etc. is used. The light source 3 reflects and condenses an emitted light to be in a predetermined direction.

The condensing lens 4 concentrates a beam from the light source 2 to the direction of the mechanical slit 5.

The mechanical slit 5 is composed of two movable plates 5A and 5B as shown in FIG. 1, and an area of an opening 5C formed between them is adjusted by moving the movable plates 5A and 5B. By adjusting the area of the opening 5C, light intensity of a light condensed by the condensing lens 4 is adjusted.

The ND filter turret 6 is supported to be able to rotate about a supporting axis 8. The ND filter turret 6 holds a plurality of kinds of ND (Neutral Density) filters along the circumferential direction. The ND filter reduces at a predetermined rate a light from the light source 3 transmitted through the mechanical slit 5 without changing the spectral composition. An ND filter to give a desired reduced light intensity is selected by determining by rotating the ND filter turret 6. Note that a mere opening is also provided to the ND filter turret 6, and a light passes through the opening as it is in the case of not reducing the light.

The color filter turret 7 is supported to be able to rotate about the supporting axis 8. The color filter turret 7 has a plurality of kinds of color filters along the circumferential direction. As a result that a light from the light source 3 passes through a color filter, a light having a wavelength in accordance with the color of the color filter is generated. A desired color filter is selected by determining by rotating the color filter turret 7. Note that a mere opening for a light to transmit is also provided to the color filter turret 7, and the light passes through the opening as it is in the case of not selecting a wavelength.

The homogenizers 9 and 11 are composed of a fly-eye lens, etc., wherein single lenses are arranged lengthwise and breadthwise to be a matrix, and are provided for equalizing an illumination distribution of a light from the light source 3.

Note that the optical system composed of the condensing lens 4, the mechanical slit 5, the ND filter turret 6, the color filter turret 7, the homogenizer 9, the reflection mirror 10, and the homogenizer 11, etc. has a function of adjusting light intensity, illumination, an illumination distribution and a wavelength, etc. of a beam from the light source 3.

The motor 30 holds the holding arm 31 to be able to rotate.

One end of the holding arm 31 is connected to a drive axis of the motor 30, and the other end holds the optical module 35.

When the holding arm 31 is rotated to the direction of an arrow A2 and placed at a predetermined position, the optical module 35 is brought to enter a light path of the optical system of the light irradiation portion 2 and aligned with a wafer W. Namely, the optical module 35 is arranged to be able to be inserted to and taken out from the light path of the optical system of the light irradiation portion 2.

The optical module 35 is irradiated with a light L output from the homogenizer 11 and irradiates the light L to the wafer W through a pin hole. Note that the specific configuration of the optical module 35 will be explained later on.

A wafer table 50 is provided with a mounting surface 50a, on which a wafer W to be tested is mounted. The mounting surface 50a is vertical with respect to a light path of the optical system of the light irradiation portion 2.

The wafer table 50 determines a position of a wafer W mounted on the mounting surface 50a within the wafer plane being vertical with respect to the light path of the optical system of the light irradiation portion 2.

When assuming that the direction of the light path of the optical system of the light irradiation portion 2 is a z-direction, mutually perpendicular directions on a plane being vertical with respect to the z-direction are a x-direction and a y-direction, and a direction of rotating the wafer table 50 is a θ-direction, a position of the mounting surface 50a can be determined in the x, y, z and θ-directions.

The probe card 20 is provided with contact probes 21 for contacting pads of a solid-state imaging device, such as a CDD, formed on the wafer W.

Also, the probe card 20 is held by a mother board 23 via a pogo tower 22.

By bringing the contact probes 21 contact the pads of the solid-state imaging device, the mother board 23 is electrically connected to the solid-state imaging device formed on the wafer W.

As a result that the solid-state imaging device formed on the wafer W and the mother board 23 are electrically connected, the measurement portion 70 supplies power to the solid-state imaging device and performs analysis, etc. by receiving an output signal of the solid-state imaging device.

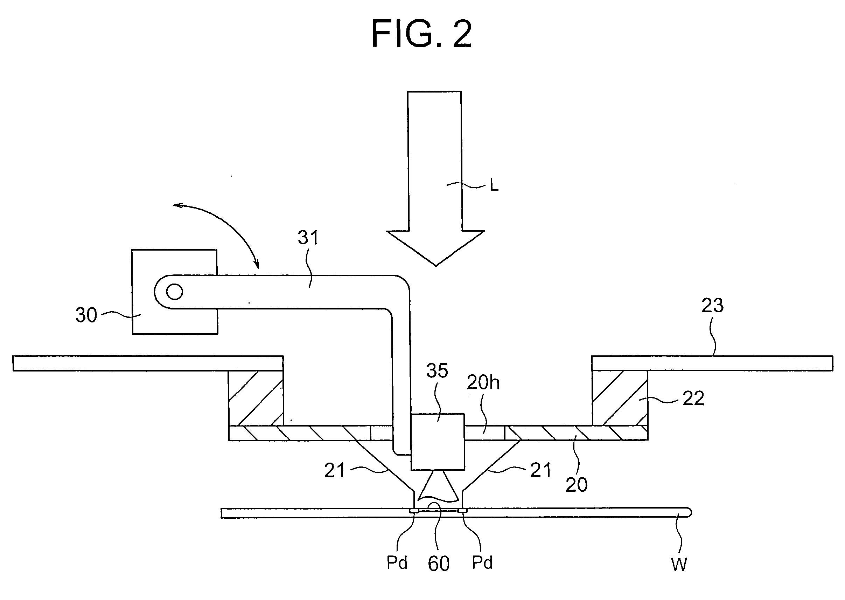

FIG. 2 is a sectional view showing the configuration of the optical module 35.

The optical module 35 is provided with, as shown in FIG. 2, a lens 36, a diffusion plate 37, a cylinder member 38, a pin hole plate 39 and a retainer ring 40.

The lens 36 condenses a light from the light source 3 guided by the homogenizer 11 of the light irradiation portion 2 configured as above. The lens 36 is formed, for example, by BK7 and silica glass, etc. An aperture H of the lens 36 is, for example, 30 mm or so in the present embodiment.

The diffusion plate 37 diffuses a light and controls light intensity, illumination and an illumination distribution to make a light intensity distribution condensed by the lens 36 to be, for example, equalized. The diffusion plate 37 is formed, for example, by glass, acryl and other resin.

The diffusion plate 37 has a three-dimensional curved surface to optimize control of an illumination distribution. The diffusion plate 37 is obtained by performing cutting processing by a ball mill or injection molding on a resin. After a predetermined shape is obtained by the cutting processing or injection molding, the surface is made rough by sand blast processing, so that it functions as a diffusion plate.

The cylinder member 38 is made by a cylinder shaped member and holds on its inner circumference the lens 36, the diffusion plate 37 and the pin hole plate 39.

The cylinder member 38 is formed by a resin, such as polycarbonate, or a metal, such as an aluminum alloy, and blocks lights. Namely, the cylinder member 38 blocks lights irradiated from the outside.

The pin hole plate 39 is made by a plate having a thickness of 30 pm to 1 mm or so and has a pin hole 39p having a predetermined diameter on an optical axis. The pin hole plate 39 is formed by a metal material, such as phosphor bronze, an aluminum alloy and stainless-steel. A diameter of the pin hole 39p is, for example, 0.1 mm to 10 mm or so in the present embodiment.

The retainer ring 40 is fixed to an upper end of the cylinder member 38 by a not shown screw and restricts movement of the lens 36 and the diffusion plate 37 in the optical axis direction.

In the optical module 35 configured as above, when assuming that a width of a light receiving surface 60 of the solid-state imaging device formed with the wafer W is "h", distance between the light receiving surface 60 and the pin hole plate 39 is "L2", distance between a lower surface of the diffusion plate 37 and the pin hole plate 39 is "L1" and an aperture of the lens 36 is "H", it is designed, so that the relationship of "h/H = L2/L1" virtually stands.

When assuming that the "L2", "h" and "H" are predetermined, a light distribution on the lower surface of the diffusion plate 37 is projected to allover the light receiving surface 60, and the "L1" and a shape of the three-dimensional curved surface of the diffusion plate 37 are determined, so that the light intensity distribution becomes, for example, equalized.

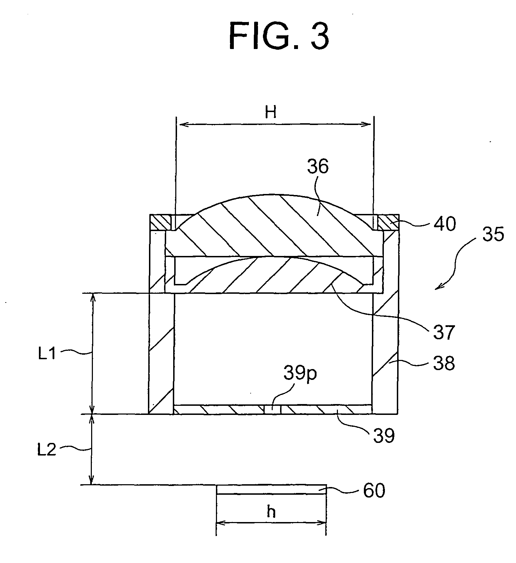

Next, an example of a testing procedure of a solid-state imaging device using a testing apparatus 1 configured as above will be explained with reference to FIG. 3.

First, the contact probes 21 of the probe card 20 are brought to contact the pads Pd of the solid-state imaging device. To bring the contact probes 21 of the probe card 20 contact the pads Pd of the solid-state imaging device, a position of the wafer stage 50 is controlled.

Next, the optical module 35 placed outside of a light path of the light irradiation portion 2 is moved to be inside the light path of the light irradiation portion 2.

As shown in FIG. 3, the optical module 35 is aligned with the light receiving surface 60 of a solid-state imaging device to be tested through an opening portion 20h formed on the probe card 20.

Consequently, a light L from the light source 3 of the light irradiation portion 2 irradiates the light receiving surface 60 through the optical module 35.

In this state, the probe card 20 is electrically connected to the pads Pd of the solid-state imaging device, and photoelectric conversion characteristics of the solid-state imaging device are measured by the mother board 23 and the measurement portion 70.

When testing the next solid-state imaging device, positions of the wafer W and the probe card 20 are changed to bring the contact probes 21 contact pads Pd of the new solid-state imaging device. As explained above, according to the present embodiment, the optical module 35 for generating a uniform light to irradiate a solid-state imaging device formed on the wafer W is made movable and aligned with the solid-state imaging device through the opening portion 20h of the probe card 20. Accordingly, the optical module 35 can be made close to the solid-state imaging device formed on the wafer W without interfering with the probe card 20. As a result, it is possible to easily handle tests of a variety of solid-state imaging devices.

### Second Embodiment

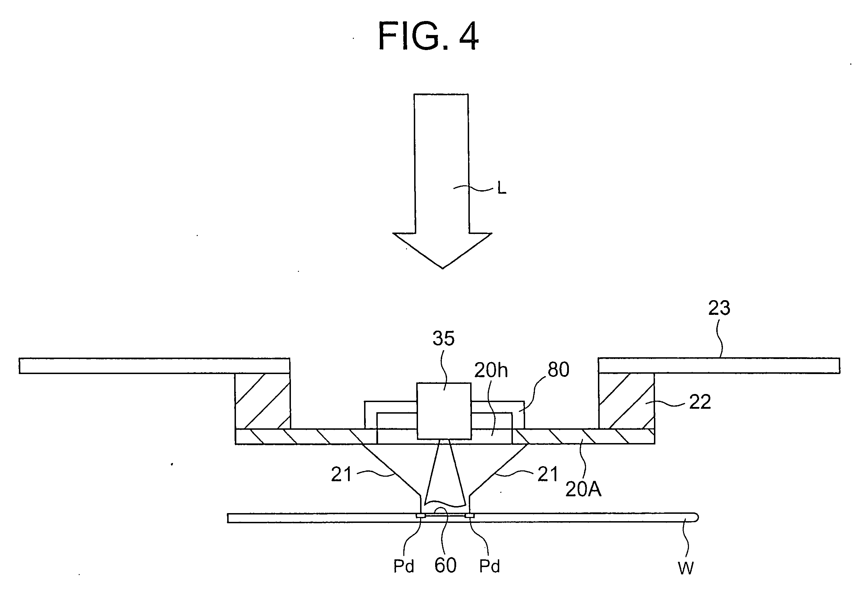

FIG. 4 is a view showing the configuration of a probe card as a relay device according to another embodiment of the present invention. Note that the same reference numbers are used for the same components as those in the first embodiment in FIG. 4.

In FIG. 4, in a probe card 20A according to the present embodiment, an optical module 35 having the same configuration as that in the first embodiment is fixed to an opening portion 20h.

The optical module 35 is fixed by a fixing member 70.

A position of the optical module 35 with respect to a light receiving surface 60 is suitably adjusted in accordance with a solid-state imaging device to be tested.

The probe card 20A is held by a mother board 23 via the above pogo tower 22.

According to the present embodiment, it is not necessary to move the optical module 35 as in the first embodiment to test photoelectric conversion characteristics of the solid-state imaging device formed on the wafer W. Therefore, the test efficiency can be widely improved.

### Third Embodiment

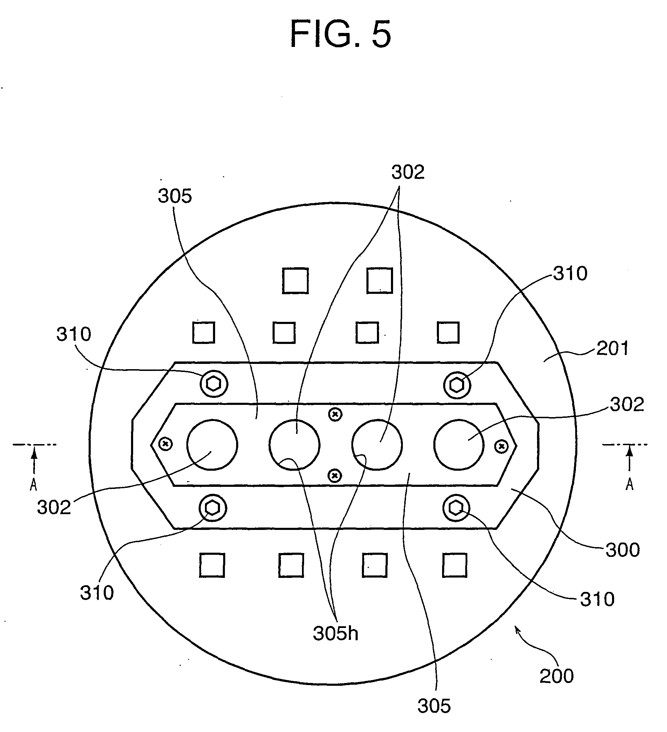

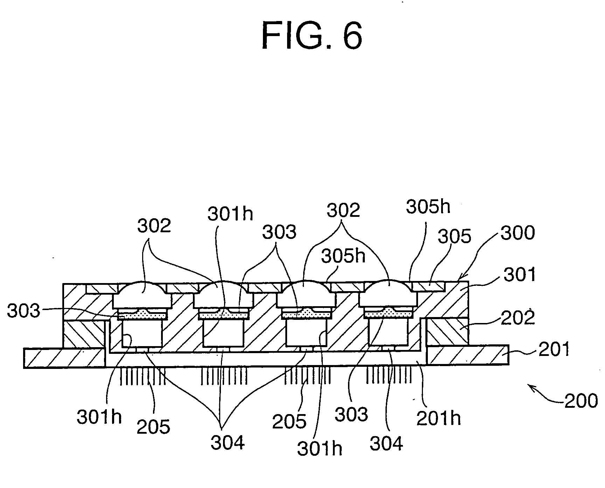

FIG. 5 is a view showing the configuration of a probe card as a relay device according to another embodiment of the present invention, and FIG. 6 is a sectional view along the line A-A in FIG. 5.

A probe card 200 shown in FIG. 5 has a card body 201 and an optical module 300.

The card body 201 of the probe card 200 basically has the same function as that of the probe cards according to the above explained embodiments, but it is different in a point that a plurality of (four) solid-state imaging devices can be tested at a time.

The probe card 200 is held by a mother board 23 via the above pogo tower 22.

The optical module 300 is provided at the center portion of the card body 201 having a disk shape.

As shown in FIG. 6, the optical module 300 is provided with holding members 301, optical lenses 302, diffusion plates 303, pin holes 304, and cover members 305.

The holding member 301 is formed with a plurality of holes 301h for forming light paths, and a pin hole 304 is formed on the bottom portion of each of the holes 301h.

On an inner circumference of a hole 301h of the holding member 301, the optical lens 302 and the diffusion plate 303 are held. The optical lens 302 is held by the upper end side of the hole 301h, and the diffusion plate 303 is held being adjacent to the optical lens 302 and away from the pin hole 304.

The holding member 301 is formed by a light blocking material. The holding member 301 is an embodiment of the light blocking portion of the present invention.

Also, the optical lenses 302, the diffusion plates 303, and the pin holes 304, etc. have the same functions as functions of those in the optical modules 35 in the above embodiments.

The cover member 305 is provided on the optical lens 302 and prevents the optical lens 302 and the diffusion plate 303 from dropping from the holding member 301. The cover member 305 is formed with an opening portion 305h for a light to transmit corresponding to each of the optical lenses 302.

The card body 200 is provided with contact probes 205 corresponding to a plurality of solid-state imaging devices.

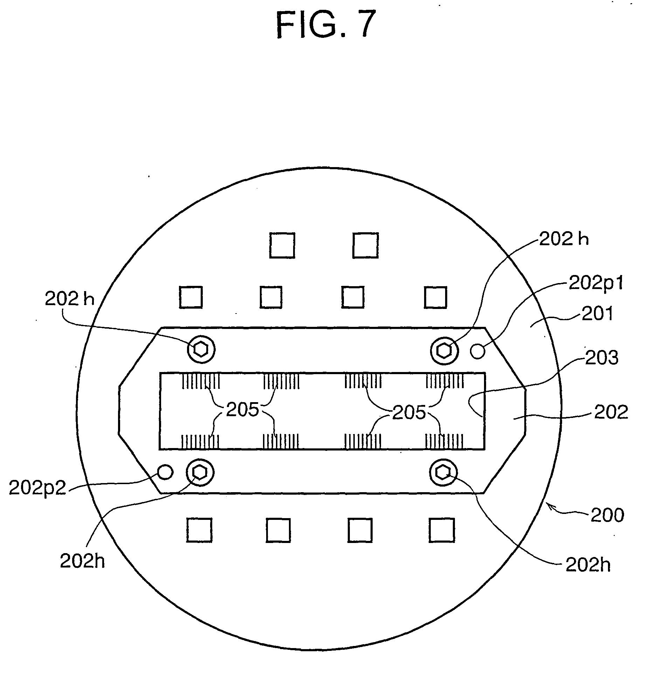

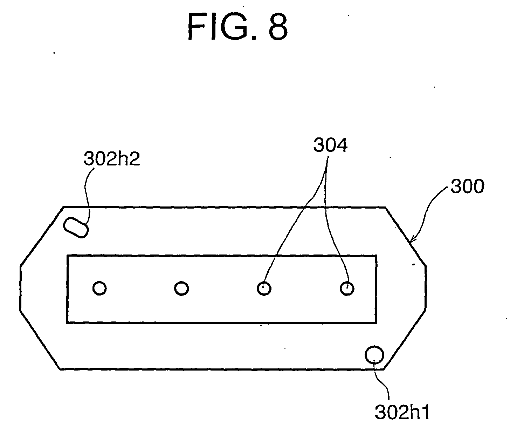

FIG. 7 is a plan view of the card body in a state where the optical module 300 is removed, and FIG. 8 is a view of the optical module 300 on the side of a surface to be mounted to the card body.

As shown in FIG. 7, in the card body 200, a rectangular-shaped opening portion 203 is provided inside a mounting portion 202.

The mounting portion 202 is formed with a screw hole 202h for a bolt 310 for fixing the optical module 300 to the mounting portion 202 to screw therein.

Also, columnar aligning pins 202p1 and 202p2 are provided at two positions on the mounting portion 202.

On the other hand, the optical module 300 is formed with aligning holes 302p1 and 302p2 for the aligning pins 202p1 and 202p2 to fit in. The aligning hole 302p1 is a circular hole and the aligning hole 302p2 is a long hole.

As a result that the aligning pins 202p1 and 202p2 fit in the aligning holes 302p1 and 302p2, the optical module 300 is positioned accurately at a predetermined position of the card body 200.

Note that the aligning pins 202p1 and 202p2 may be provided on the optical module 300 side, and the aligning holes 302p1 and 302p2 may be formed on the mounting portion 202.

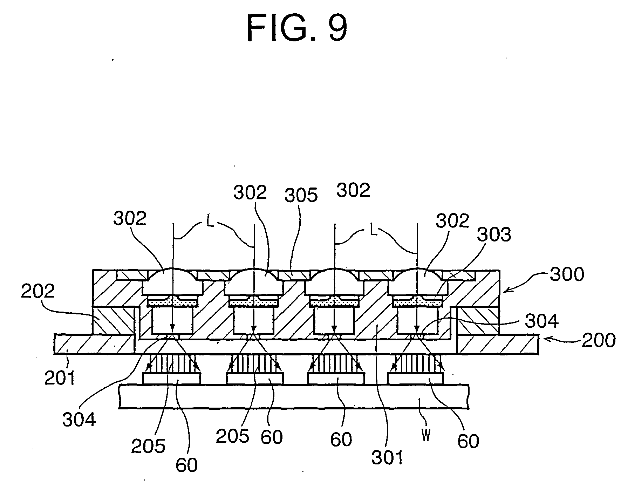

As shown in FIG. 9, when a light L is irradiated to the respective optical lenses 302 in a state where the contact probes 205 of the probe card 200 configured as above contact pads of respective solid-state imaging devices 60 on wafers W, test lights are irradiated through the respective pin holes 304 to the respective solid-state imaging devices 60.

At this time, the respective diffusion plates 303 are arranged close to the optical lenses 302 and away from the pin holes 304, so that lights irradiated from the respective pin holes 304 do not diffuse to sides and adjacent test lights do not interfere with one another.

Namely, the closer the diffusion plates 303 are to the pin holes 304 side, the more the test lights diffuse due to the action of the diffusion plates 303, and the test lights from adjacent pin holes 304 become easily interfere with one another. But when the diffusion plates 303 are arranged close to the optical lenses 302 and away from the pin holes 304, diffusion of the test lights can be suppressed.

### Fourth Embodiment

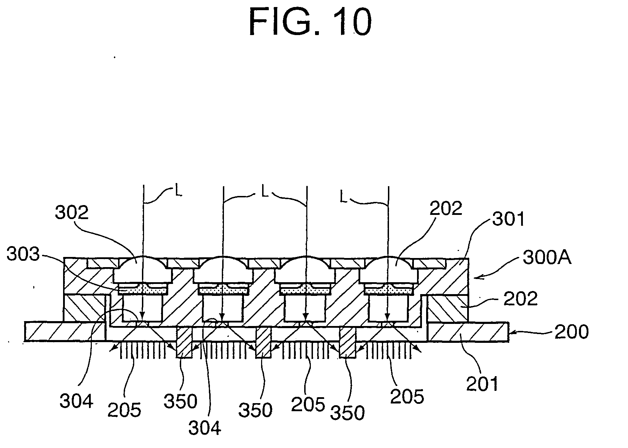

FIG. 10 is a view showing the configuration of a probe card as a relay device according to still another embodiment of the present invention.

The basic configuration of a probe card 200A shown in FIG. 10 is the same as that of the probe card 200 explained in the third embodiment, but it is different in a point that a light blocking plate 350 is provided. The light blocking plate 350 is an embodiment of the light blocking means of the present invention.

The light blocking plate 350 is provided on a lower surface of a holding member 301 of an optical module 300A so as to prevent test lights irradiated from adjacent pin holes 304 from interfering with one another.

Note that the light blocking plate 350 may be formed to be one body with the holding member 301.

In the present embodiment, by providing the light blocking plate 350, test lights irradiated from adjacent pin holes 304 can be prevented from interfering with one another even when diffusion plates 303 are placed close to the pin hole 304 side, so that the degree of freedom in designing can be made high.

### Fifth Embodiment

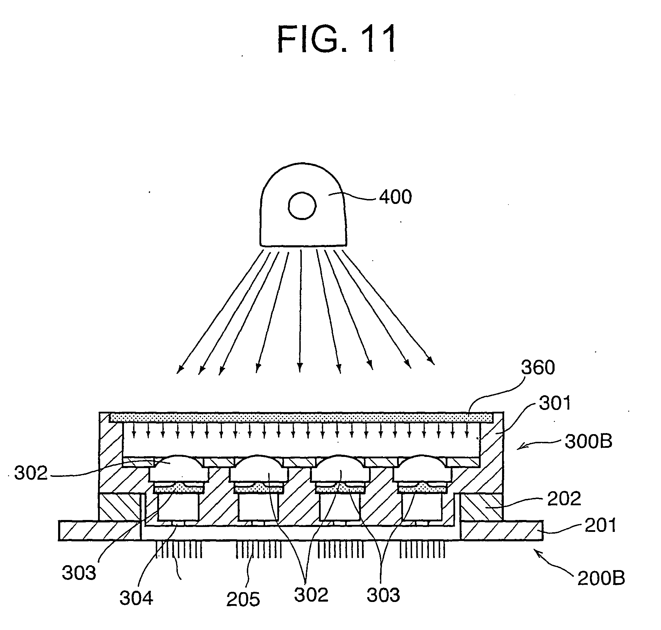

FIG. 11 is a view of the configuration of a probe card as a relay device according to furthermore another embodiment of the present invention.

The basic configuration of a probe card 200B shown in FIG. 11 is the same as that of the probe card 200 explained in the third embodiment, but it is different in a point that a common diffusion plate 360 is provided. A light blocking plate 350 is an embodiment of the light blocking means of the present invention.

The common diffusion plate 360 is arranged on a plurality of optical lenses 302 in common and provided for making incident angles of lights to be irradiated to the respective optical lenses 302 uniform.

For example, as shown in FIG. 11, when irradiating a light by arranging a light source 400 on an optical module 300B, light incident angles vary depending on positions of the respective optical lenses 302. Therefore, an intensity distribution of test lights emitted from respective pin holes 304 easily becomes uneven and conditions of the test lights easily vary.

By providing the common diffusion plate 360, incident angles of lights irradiated to the respective optical lenses 302 are made uniform, and conditions of the test lights emitted from the respective pin holes 304 are made uniform.

As a result, a plurality of solid-state imaging devices can be tested by test lights of the same condition at a time.

### Sixth Embodiment

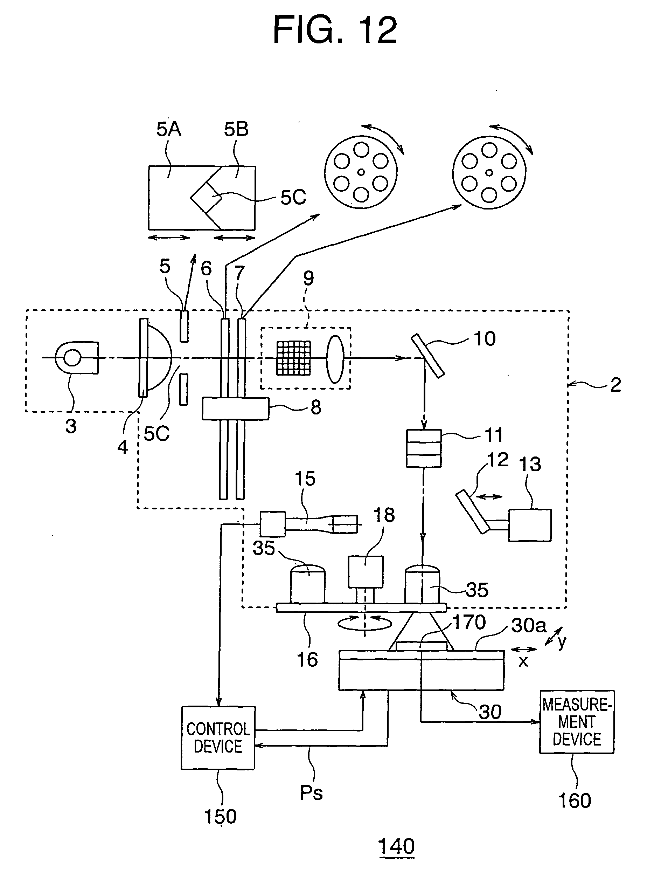

FIG. 12 is a view of the configuration of a testing apparatus of a solid-state imaging device according to an embodiment of the present invention. Note that the same reference numbers are used for the same components as those in the first embodiment in FIG. 12.

In FIG. 12, a testing apparatus 140 has a light irradiation portion 2, an X-Y table 30, a control device 150 and a measurement device 160. Note that the X-Y table 30 is an embodiment of the moving table of the present invention, and the control device 150 is an embodiment of the control means of the present invention.

The light irradiation portion 2 has a light source 3, a condensing lens 4, a mechanical slit 5, an ND filter turret 6, a color filter turret 7, homogenizer 9, a reflection mirror 10, a homogenizer 11, an optical module 35, turret 16, a half mirror 12 and a CCD camera 15.

The light source 3, the optical module 35, the half mirror 12 and the CCD camera 15 are embodiments of the light source, optical module, half mirror and imaging means of the present invention, respectively.

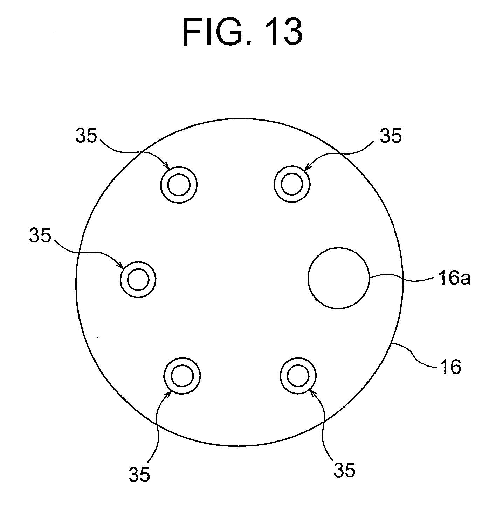

Here, FIG. 13 is a plan view showing the configuration of the turret 16.

As shown in FIG. 13, the turret 16 is provided with a plurality of optical modules 35 at even intervals on the same circumference. Also, an opening 16a is formed on the circumference provided with the optical modules 35.

Positions provided with the optical modules 35 on the turret 16 are formed with openings 16b having a smaller diameter than that of the opening 16a, respectively.

The turret 16 is supported to be able to rotate by the determining mechanism 18 as shown in FIG. 12. By determining a desired rotation angle of the turret 16 by the determining mechanism 18, any optical module 35 or opening 16a is placed on a light path of the optical system explained above.

Note that the optical modules 35 have the same configuration as that in the first embodiment explained above, but the plurality of optical modules 35 have respectively different optical characteristics.

Returning back to FIG. 12, the half mirror 12 is supported by a moving mechanism 13 and able to be inserted to a light path of the optical system of the light irradiation portion 2 (between the homogenizer 11 and an optical module 35) by the moving mechanism 13.

In the above light path, the half mirror 12 transmits a light from the homogenizer 11 side and reflects an image on the optical module 35 side to the direction perpendicular to the light path.

The CCD camera 15 is arranged at a position of enabling to pickup an image reflected by the half mirror 12. The CCD camera 15 outputs picked up image data to the control device 150.

The control device 150 drives and controls the X-Y table 30 based on positional information Ps obtained from the X-Y table 30. The positional information Ps is detected, for example, by a position detector, such as a linear scale provided in the X-axis direction and Y-axis direction of the X-Y table 30.

Also, the control device 150 stores positional data of an optical axis of the optical modules 35 arranged on the light path of the optical system explained above and determines a target position for the X-Y table 30 to move to based on the positional data of the optical axis of the optical module 35.

The X-Y table 30 has a mounting surface 30a to be mounted with a solid-state imaging device 170 to be tested. The mounting surface 30a is vertical with respect to the light path of the optical system of the light irradiation portion 2.

The X-Y table 30 determines a position of the solid-state imaging device 170 mounted on the mounting surface 30a on an X-Y plane being vertical with respect to the light path of the optical system of the light irradiation portion 2.

Also, the solid-state imaging device 170 mounted at a predetermined position on the mounting surface 30a of the X-Y table 30 is electrically connected to the measurement device 160.

As a result that the measurement device 160 is electrically connected to the solid-state imaging device 170, it performs analysis, etc. by supplying power to the solid-state imaging device 170 and receiving an output signal of the solid-state imaging device 170.

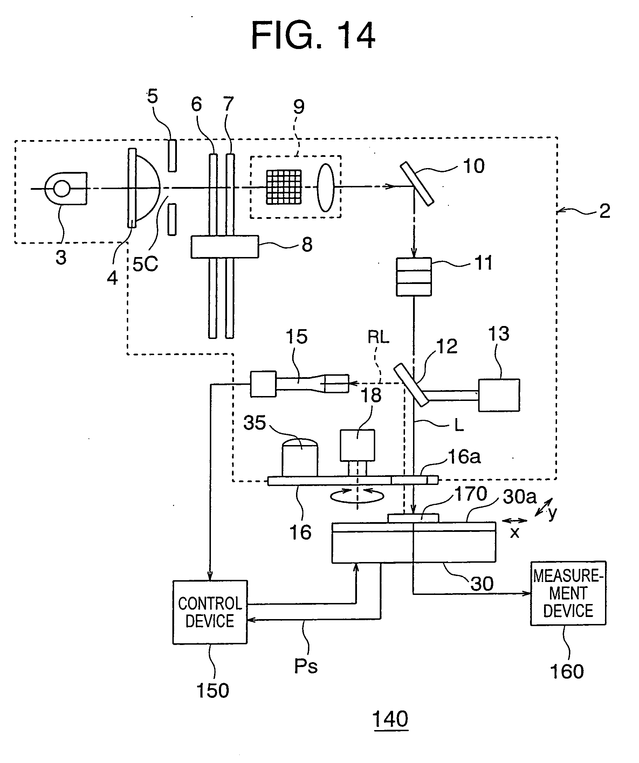

Next, an example of a test procedure of a solid-state imaging device using a testing apparatus 140 configured as above will be explained with reference to FIG. 14.

FIG. 14 is a view showing a state of the testing apparatus 140 before testing a solid-state imaging device.

First, the solid-state imaging device 170 to be tested is aligned to be a predetermined position (a position able to be irradiated with a light from the light irradiation portion 2) on the mounting surface 30a of the X-Y table 30 by a handler.

At this time, alignment accuracy of the handler is normally not as high as accuracy of pitches between respective light receiving elements provided to the solid-state imaging device 170.

From this state, as shown in FIG. 14, the half mirror 12 is inserted to the light path of the optical system of the light irradiation portion 2 by driving the moving mechanism 13.

Also, determination of the turret 16 is made to arrange an opening 16a on the turret 16 in the light path of the optical system of the light irradiation portion 2. Furthermore, a light is emitted from the light source 3.

The light from the light source 3 is guided to a predetermined light path, transmits the half mirror 12 and irradiates the solid-state imaging device 170 through the opening 16a of the turret 16.

At this time, the light is irradiated to a sufficiently wider range than the shape of the solid-state imaging device 170. Consequently, an overall image of the solid-state imaging device 170 is reflected by the half mirror 12 and the overall image of the solid-state imaging device 170 is picked up by the CCD camera 15. Data of the picked up image data is input to the control device 150.

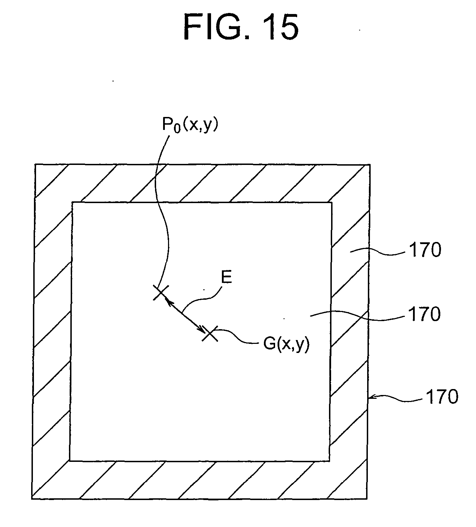

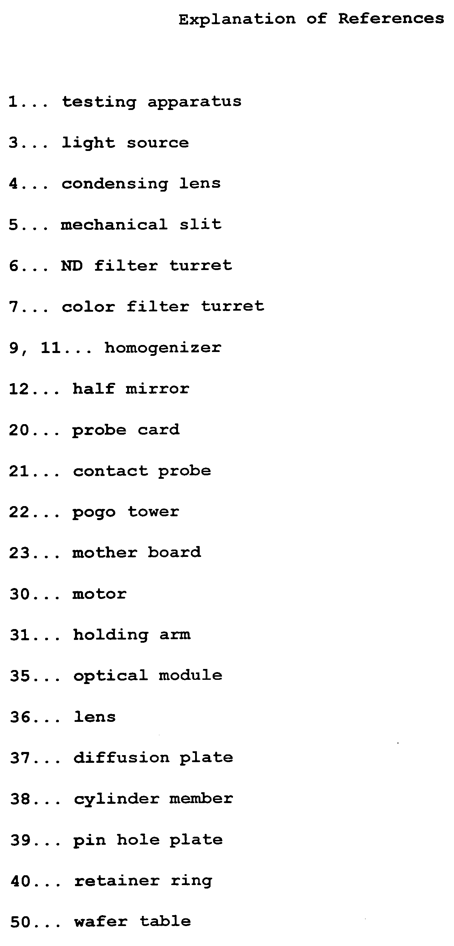

Here, FIG. 15 is a view showing an example of the overall image of the solid-state imaging device 170 picked up by the CCD camera 15.

As shown in FIG. 15, the solid-state imaging device 170 has a rectangular shaped light receiving portion 170a, wherein a large number of light receiving elements are arranged lengthwise and breadthwise, and a peripheral portion 170b surrounding the light receiving portion 170a.

When picking up an overall image of the solid-state imaging device 170 by the CCD camera 15 in a state where a light is irradiated to the whole solid-state imaging device 170, shading becomes different between the light receiving portion 170a and the peripheral portion 170b in the image. For example, the light receiving portion 170a becomes bright and the peripheral portion 170b becomes dark in the image. Therefore, a boundary of the light receiving portion 170a and the peripheral portion 170b appears clearly in the image data.

The control device 150 extracts the light receiving portion 170a from the above image data and calculates an X-Y coordinate of a barycentric position G of the extracted light receiving portion 170a. The calculation of the X-Y coordinate of the barycentric position G is performed by a well-known image processing technique.

Next, the control device 150 compares the calculated X-Y coordinate of the barycentric position G with a previously stored X-Y coordinate of a position P₀ of an optical axis of the optical module 35 arranged in the light path of the optical system explained above. The X-Y coordinate of the position P₀ is a coordinate of a center axis of a pin hole of the optical module 35. Position deviation E of the barycentric position G and the position P0 is calculated.

Next, the control device 150 drives the X-Y table 30 to cancel the position deviation E. As a result, the barycentric position G of the solid-state imaging device 170 substantially matches with the position P₀ of the optical axis of the optical module 17 stored in advance.

Next, as shown in FIG. 13, the half mirror 12 is moved to outside the light path, furthermore, an optical module 35 to be used for the test is determined.

Consequently, a light from the light source 3 is irradiated to the solid-state imaging device 170 through a pin hole of the optical module 35.

When irradiating a light to the solid-state imaging device 170 through the pin hole of the optical module 35, photoelectric conversion is performed in the respective light receiving elements of the solid-state imaging device 170 and an electric signal is input to the measurement device 160.

The measurement device 160 measures photoelectric conversion characteristics of the solid-state imaging device 170 based on the electric signal from the solid-state imaging device 170.

As explained above, in the present embodiment, every time photoelectric conversion characteristics of the solid-state imaging device 170 is measured by irradiating a light to the solid-state imaging device 170 through the pin hole of the optical module 35, image data of the light receiving surface 170a of the solid-state imaging device 170 is obtained first by using the light from the light source 3 of the light irradiation portion 2. A position to be a reference of the light receiving surface 170a, such as a barycentric position, is calculated from the image data.

When the calculated barycentric position does not match with the center axis (optical axis) of the pin hole stored in advance, the X-Y table 30 is driven to make it match.

Consequently, when irradiating a light to the solid-state imaging device 170 through the pin hole of the optical module 35, the pin hole and the light receiving surface 170a always come to be in a certain positional relationship.

As a result, an incident angle of the light to the solid-state imaging device 170 becomes constant in each measurement, an output of the solid-state imaging device 170 does not vary, and photoelectric conversion characteristics of the solid-state imaging device 170 can be accurately measured. Particularly, a micro lens is arranged above each light receiving element, an equivalent aperture ratio is made high, and measurement accuracy of a solid-state imaging device having improved sensitivity can be widely improved.

Also, according to the present embodiment, a light of the light source 3 of the light irradiation portion 2 is used, a half mirror is inserted to a light path of the light irradiation portion 2, and an image of the light receiving surface 170a of the solid-state imaging device 170 is picked up by the CCD camera 15 located in advance in the light irradiation portion 2. Therefore, an alignment operation on the pin hole of the optical module 35 and the solid-state imaging device 170 can be incorporated in a series of test operations on the solid-state imaging device 170, and a decline of the test efficiency can be suppressed to minimum.

Note that the present invention is not limited to the above embodiments,

In the above embodiments, it was configured that the optical axis of the light irradiation portion 2 and the barycentric position G of the light receiving surface 200a of the solid-state imaging device 170 were made to be matched by mounting the solid-state imaging device 170 on the X-Y table 30 and driving the X-Y table 30. On the other hand, it may be also configured that the light irradiation portion 2 side is made movable and the solid-state imaging device 170 is mounted on the fixed table.

Also, in the first embodiment, the case of using a motor and a holding arm as the moving position determination means of the present invention was explained, but it is not limited to this as far as it is a means capable of moving and determining a position without interfering with the probe card 20. By configuring as such, the test efficiency can be furthermore improved.

In the first to fifth embodiments explained above, the case of a probe card was explained as the repeating means and the relay device of the present invention, but the present invention is not limited to this.

For example, those used at the time of testing a packaged solid-state imaging device, such as a socket board, and a mother board to be connected to the probe card and the socket board are also included in the repeating means and relay device. Also, those in a state where the probe card, the socket board and the mother board are connected may be used as the repeating means and relay device. It is sufficient if these boards are formed with an opening portion and the optical module of the present invention is provided. Also, the position of arranging the optical module may be on the socket, etc. other than the board.

### Industrial Applicability

The present invention can be used for testing a solid-state imaging device, such as a CCD (Charge Coupled Device) and a CMOS (Complementary Metal Oxide Semiconductor).

## Claims

1. An optical module arranged facing a light receiving surface of a solid-state imaging device and used for irradiating a test light for said light receiving surface at testing photoelectric converting property of said solid-state imaging device, comprising:
an optical lens;
a diffusion plate adjusting an intensity distribution of a light passed through said optical lens;
a pinhole passing said light from said diffusion plate; and
a light blocking portion preventing an outside light from entering into an optical path leading from said lens to said pinhole.

2. An optical module as set for claim 1 comprising a plurality of sets of said optical lens, said diffusion plate and said pinhole.

3. An optical module as set forth in claim 2 further comprising a light blocking means for preventing said lights output from adjacent pinholes from interfering mutually.

4. An optical module as set forth in claim 1, wherein said diffusion plate comprises a three dimensional curved surface for adjusting said intensity distribution of said light.

5. An optical module as set forth in claim 2 further comprising a common diffusion plate for equalizing incident angles of lights entering into a plurality of said optical lenses.

6. An optical module as set forth in claim 2, wherein said diffusion plate is set near to said optical lens and apart from said pinhole.

7. A relay device transmitting necessary signals for a measurement of a photoelectric converting property of a solid-state imaging device by being connected electrically to said solid-state imaging device to be measured at testing said photoelectric converting property of said solid-state imaging device, comprising:
an optical module arranged facing a light receiving surface of said solid-state imaging device and used for irradiating a test light for said light receiving surface at testing photoelectric converting property of said solid-state imaging device.

8. A relay device as set forth in claim 7 comprising
a mounting portion for mounting said optical module and
a means for determining positions of said mounting portion and said optical module.

9. A relay device as set forth in claim 8, wherein
said means for determining positions comprises a position determination pin and a position determination hole to be fit and inserted by said position determination pin formed at said optical module side.

10. A relay device as set forth in claim 8, wherein
said mounting portion comprises an opening passing said light output through said optical module and proceeding to said light receiving surface of said solid-state imaging device.

11. A relay device as set forth in claim 8, wherein said optical module comprises
an optical lens,
a diffusion plate adjusting an intensity distribution of a light passed through said optical lens;
a pinhole passing said light from said diffusion plate, and
a light blocking portion preventing an outside light from entering into an optical path leading from said lens to said pinhole.

12. A testing apparatus for irradiating a light for a solid-state imaging device and testing a photoelectric converting property of said solid-state imaging device, comprising:
an optical module outputting an entered light as a test light through a pinhole;
a relay device transmitting necessary signals for a measurement of said photoelectric converting property of said solid-state imaging device by being connected electrically to said solid-state imaging device; and
a means for moving and determining position moving said optical module at a position capable of outputting said light for said solid-state imaging device at a state that said relay device is connected electrically with said solid-state imaging device.

13. A testing apparatus as set forth in claim 12, wherein
said relay device comprises an opening portion for making said optical module faces a light receiving surface of said solid-state imaging device and
said a means for determining position determines position of said optical module capable of irradiating for said light receiving surface of said solid-state imaging device through said opening portion.

14. A testing apparatus as set forth in claim 12, wherein said optical module comprises
an optical lens,
a diffusion plate adjusting an intensity distribution of a light passed through said optical lens;
a pinhole passing said light from said diffusion plate, and
a light blocking portion preventing an outside light from entering into an optical path leading from said lens to said pinhole.

15. A testing apparatus for irradiating a light for a solid-state imaging device and testing a photoelectric converting property of said solid-state imaging device, comprising:
an optical module irradiating a light lead along a predetermined optical path from a light source for said solid-state imaging device through a pinhole;
a moving table holding said solid-state imaging device capable of moving in a plane being vertical to a light axis of said optical module;
a means for moving said optical module outside said predetermined optical path;
a half mirror inserted in said predetermined optical path at a state that said optical module is moved outside said optical path, transmitting said light from said light source proceeding to said solid-state imaging device, and reflecting a image of said solid-state imaging device irradiated by said light;
a means for imaging said image reflected by said half mirror;
a means for controlling said moving table so that said optical axis of said optical module is positioned at a predetermined position of said light receiving surface based on a graphic date of said light receiving surface imaged by said means for imaging.

16. A testing apparatus as set forth in claim 15, wherein
said means for controlling calculates a center of gravity of said light receiving surface from said graphic date, and control said moving table based on said center of gravity and a date of position of said optical axis of said optical module memorized in advance.
